(19) Europäisches Patentamt European Patent Office Office européen des brevets

(11) EP 4 502 522 A1

(12) **EUROPEAN PATENT APPLICATION**
published in accordance with Art. 153(4) EPC

(43) Date of publication:
05.02.2025 Bulletin 2025/06

(21) Application number: 23780533.8

(22) Date of filing: 28.03.2023

(51) International Patent Classification (IPC):
*F28D 15/02* (2006.01)    *F28D 15/04* (2006.01)

(52) Cooperative Patent Classification (CPC):
F28D 15/02; F28D 15/04

(86) International application number:
PCT/JP2023/012540

(87) International publication number:
WO 2023/190524 (05.10.2023 Gazette 2023/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 30.03.2022 JP 2022055454

(71) Applicant: Kyocera Corporation
Kyoto-shi, Kyoto 612-8501 (JP)

(72) Inventor: KONISHI Yoshitada
Kyoto-shi, Kyoto 612-8501 (JP)

(74) Representative: Viering, Jentschura & Partner
mbB
Patent- und Rechtsanwälte
Am Brauhaus 8
01099 Dresden (DE)

(54) **HEAT DISSIPATION PLATE AND VAPOR CHAMBER**

(57) A heat dissipation plate includes a substrate including a first main surface and a second main surface located on a side opposite to the first main surface, and a plurality of needle-shaped bodies extending outward of the substrate from the first main surface. A positioning part where fluid is positioned is provided between respective ones of the plurality of needle-shaped bodies. A portion of the substrate is made of ceramic, the portion including at least a part of the first main surface. The needle-shaped body is a needle-shaped crystal of ceramic.

FIG. 1B

EP 4 502 522 A1

## Description

TECHNICAL FIELD

The present disclosure relates to a heat dissipation plate and a vapor chamber.

BACKGROUND OF INVENTION

Patent Literature 1 describes a configuration in which a plate-shaped heat pipe (that is, a vapor chamber) includes in its internal space a wick.

CITATION LIST

PATENT LITERATURE

Patent Literature 1: Japanese Unexamined Patent Application Publication No. 2003-254685

SUMMARY

PROBLEM TO BE SOLVED

A vapor chamber in the related art requires a comparatively high cost to include a wick in an internal space of the vapor chamber. The present disclosure provides, at a low cost, a heat dissipation plate including a structure capable of holding liquid-phase fluid (that is, liquid) near a substrate surface. The present disclosure further provides a vapor chamber including the heat dissipation plate.

SOLUTION TO PROBLEM

According to the present disclosure, a heat dissipation plate includes a substrate and a plurality of needle-shaped bodies. The substrate includes first main surface and a second main surface located on a side opposite to the first main surface. The plurality of needle-shaped bodies extends outward of the substrate from the first main surface. A positioning part where fluid is positioned is provided between respective ones of the plurality of needle-shaped bodies. A portion of the substrate is made of ceramic, the portion including at least a part of the first main surface. The needle-shaped body is a needle-shaped crystal of the ceramic.

According to the present disclosure, a vapor chamber includes the heat dissipation plate described above, a housing, and liquid-phase fluid. The housing includes an opening. The liquid-phase fluid is located inside the housing. The heat dissipation plate covers the opening. The plurality of needle-shaped bodies is located inside a space surrounded by the housing and the substrate.

ADVANTAGEOUS EFFECT

The present disclosure can provide, at a low cost, a heat dissipation plate including a structure capable of holding liquid-phase fluid near a substrate surface, and a vapor chamber.

BRIEF DESCRIPTION OF THE DRAWINGS

FIG. 1A is an exploded perspective view illustrating a heat dissipation plate and a vapor chamber according to Embodiment 1.
FIG. 1B is a sectional view illustrating the heat dissipation plate and the vapor chamber according to Embodiment 1.
FIG. 2A is a perspective view illustrating a backside of the heat dissipation plate of Embodiment 1.
FIG. 2B is a perspective view illustrating a backside of a heat dissipation plate of a variation.
FIG. 3 is a view for explaining a needle-shaped body.
FIG. 4A is a side view for explaining a pair of needle-shaped bodies intersecting with one another.
FIG. 4B is a plan view for explaining a pair of needle-shaped bodies intersecting with one another.
FIG. 5A is a view for explaining a first aspect of intersection of a pair of needle-shaped bodies intersecting with one another.
FIG. 5B is a view for explaining a second aspect of intersection of a pair of needle-shaped bodies intersecting with one another.
FIG. 6A is a view for explaining an arrangement example of a pair of needle-shaped bodies with the intersection of the first aspect and a pair of needle-shaped bodies with the intersection of the second aspect and is a view for explaining a flow of gas-phase fluid and liquid-phase fluid.
FIG. 6B is a view for explaining an arrangement example of a pair of needle-shaped bodies with the intersection of the first aspect and a pair of needle-shaped bodies with the intersection of the second aspect and is a view illustrating a placement region on a first main surface.
FIG. 7A is a side view illustrating a plurality of needle-shaped bodies.
FIG. 7B is a cross-sectional view of a needle-shaped body.
FIG. 8A is a vertical-sectional view illustrating a heat dissipation plate and a vapor chamber according Embodiment 2.
FIG. 8B is a plan view illustrating the heat dissipation plate and the vapor chamber according to Embodiment 2.
FIG. 9A is a vertical-sectional view illustrating a heat dissipation plate and a vapor chamber according Embodiment 3.
FIG. 9B is a plan view illustrating the heat dissipation plate and the vapor chamber according to Embodiment 3.

FIG. 10A is a view illustrating a vapor chamber according Embodiment 4.

FIG. 10B is a view illustrating a vapor chamber according Embodiment 5.

DESCRIPTION OF EMBODIMENTS

Hereinafter, embodiments of the present disclosure are described in detail with reference to the drawings.

(EMBODIMENT 1)

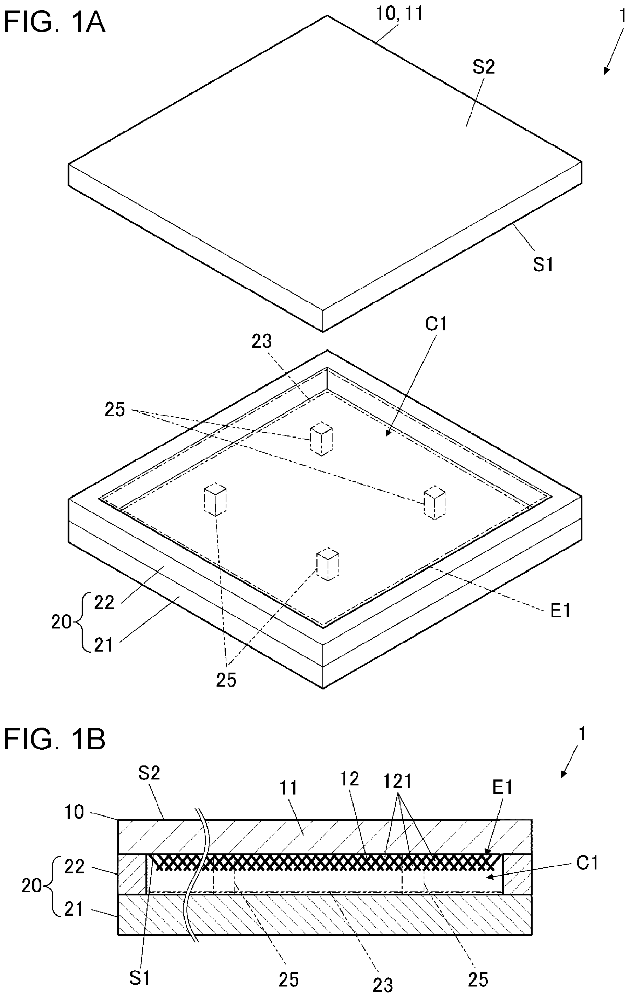

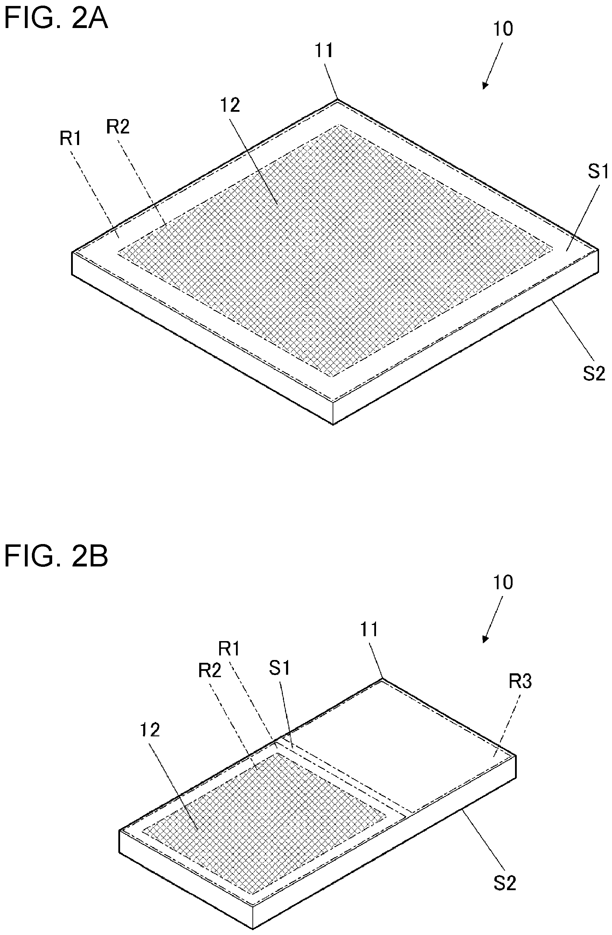

FIG. 1A is an exploded perspective view illustrating a heat dissipation plate and a vapor chamber according to Embodiment 1. FIG. 1B is a sectional view illustrating the heat dissipation plate and the vapor chamber according to Embodiment 1. FIG. 2A is a perspective view illustrating a backside of the heat dissipation plate of Embodiment 1. FIG. 2B is a perspective view illustrating a backside of a heat dissipation plate of a variation. A needle-shaped body illustrated in FIGs. 2A and 2B is a schematic.

According to Embodiment 1, a vapor chamber 1 includes a heat dissipation plate 10, and a housing 20 including an opening E1 (see FIG. 1A). The housing 20 may include a space C1, such as a recess, to be a sealed chamber when the opening E1 is closed.

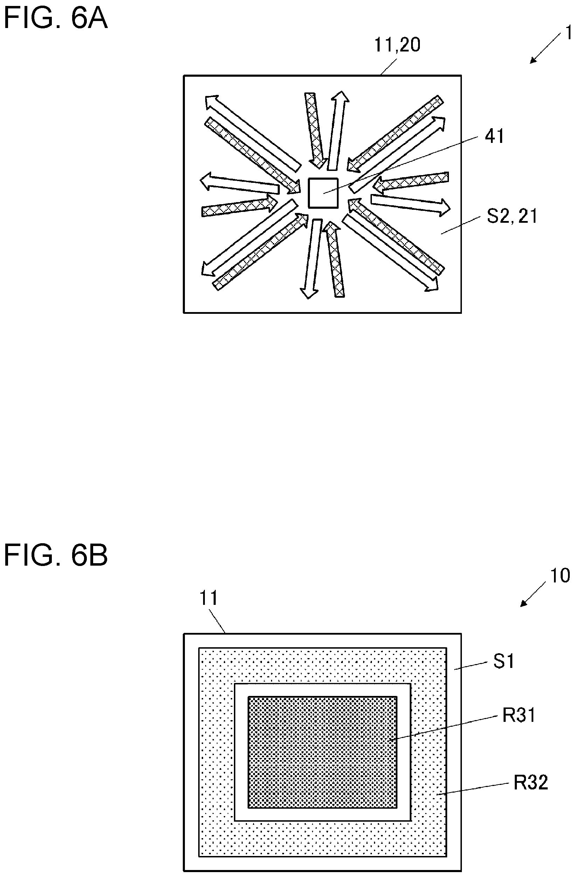

The heat dissipation plate 10 may be joined to the housing 20 in such a manner as to cover the opening E1. The space C1 surrounded by the heat dissipation plate 10 and the housing 20 may contain liquid-phase fluid (for example, water) by an amount which does not fill up the space C1. The space may also have a reduced pressure. The heat dissipation plate 10 or the housing 20 may include, as indicated by an imaginary line in FIGs. 1A and 1B, one or more pillar-like parts 25 supporting the space described above. The pillar-like part 25 may not be provided. The pillar-like part 25 may be made of ceramic and formed integrally with the heat dissipation plate 10 or the housing 20. Alternatively, the pillar-like part 25 may be made of metal and formed integrally with the housing 20. The pillar-like part 25 may have, when seen in transparent plan view, a form longer in a radial direction centering on a heat source 41 (see FIG. 6A) (that is, longer than a length in a circumferential direction centering on the heat source 41). The transparent plan view means to see through an object in a direction perpendicular to a first main surface S1.

The housing 20 may be made of metal such as copper or made of ceramic. The housing 20 may include a plate-shaped part 21 opposed to the heat dissipation plate 10, and a frame part 22 surrounding a space inside the opening E1 from a side. The plate-shaped part 21 and the frame part 22 may integrally be formed or may be joined to one another. The plate-shaped part 21 and the frame part 22 may be made of the same material or different materials. For example, one of the plate-shaped part 21 or the frame part 22 may be made of metal, and the other one of the plate-shaped part 21 or the frame part 22 may be made of ceramic.

The heat dissipation plate 10 may include a substrate 11 including the first main surface S1 and a second main surface S2, and a plurality of needle-shaped bodies 12 extending outward of the substrate 11 from the first main surface S1. The first main surface S1 and the second main surface S2 mean two surfaces with front areas larger than areas of the other surfaces when the substrate 11 is seen from multiple directions. The first main surface S1 and the second main surface S2 may be surfaces located on sides opposite to one another.

The substrate 11 may be made of ceramic. The needle-shaped body 12 may be a ceramic needle-shaped crystal. The ceramic may include, as a main component, silicon nitride ($Si_3N_4$), silicon carbide (SiC), mullite, or aluminum nitride (AIN). The main component means a component with a mass ratio of 80% or more. The entirety of the substrate 11 is not necessarily made of ceramic, but a portion including a part of the first main surface S1 may be made of ceramic.

As illustrated in FIGs. 2A and 2B, the plurality of needle-shaped bodies 12 may be located in a region R2 of the first main surface S1. The region R2 faces the opening E1 of the housing 20. A variation illustrated in FIG. 2B is an example in which a width of the substrate 11 is larger than a width of the housing 20.

A positioning part 121 (that is, a gap) where fluid is positioned is provided between the respective ones of the plurality of needle-shaped bodies 12. That is, in a case in which the substrate 11 alone is provided, fluid such as air may be positioned at the positioning part 121. In a case in which the substrate 11 is applied to the vapor chamber 1, liquid-phase fluid or gas-phase fluid may be positioned at the positioning part 121. In the above-described configuration, the needle-shaped body 12 can demonstrate a function as a wick of the vapor chamber 1. The wick corresponds to a configuration capable of holding and/or conveying liquid-phase fluid by surface tension of a fine linear body. In the above-described configuration, the needle-shaped body 12 is a ceramic needle-shaped crystal and can be formed through firing of ceramic. Therefore, providing the heat dissipation plate 10 capable of holding liquid-phase fluid near a surface of the first main surface S1 at a low cost is possible.

The positioning part 121 may hold liquid-phase fluid. That is, the positioning part 121 may be referred to as a holding part which holds liquid-phase fluid. The positioning part 121 may have the following characteristic to hold liquid-phase fluid. That is, the positioning part 121 may have a characteristic that when the first main surface S1 is soaked in water and then exposed to air while facing vertically downward, water collects at the gap between the multiple needle-shaped bodies 12 (for example, water collects at the gap five times or more the amount at a flat surface). Adjustment of a density and an arrangement aspect (for example, inclination and/or a degree of variation in an inclination direction) of the plurality of needle-shaped bodies 12 can achieve this characteristic. This characteristic can enhance the function of the needle-shaped body 12 as a wick. Liquid-phase fluid may be water, acetone, ammonia, or the like.

The second main surface S2 of the substrate 11 may be flatter than the region R2 where the needle-shaped body 12 is located. Being flat means to be flat when compared to the region R2 that is non-flat due to existence of the plurality of needle-shaped bodies 12, but not to the region R2 excluding the needle-shaped body 12. Being flat as described above may mean a degree where no needle-shaped crystal or an extremely short needle-shaped crystal exists. The second main surface S2 may be a planar shape. The second main surface S2 may include a stepped portion, a protrusion, and/or a recess. However, an upper surface of the stepped portion, an upper surface of the protrusion, and/or an inner bottom surface of the recess may be flatter than the region R2 where the needle-shaped body 12 is located or have a planar shape. In this configuration, a part of the second main surface S2 can be a surface on which an electronic element that serves as a heat source is mounted. Alternatively, in a case in which the heat dissipation plate 10 is mounted on a module substrate, the second main surface S2 is adoptable as a surface opposed to the module substrate.

As illustrated in FIGs. 2A and 2B, the first main surface S1 of the substrate 11 may include a joint region R1 to which an upper surface of the frame part 22 (that is, a surface at a periphery of the opening E1 of the housing 20) is joined. The joint region R1 may have an annular shape. The region R2 where the needle-shaped body 12 is located may be located on an inner side of the joint region R1 in such a manner as to be surrounded by the joint region R1. The joint region R1 is flatter than the region R2 where the needle-shaped body 12 is located and may have a planar shape. Being flat as described above may mean a degree where no needle-shaped crystal or an extremely short needle-shaped crystal exists. In this configuration, joining between the housing 20 and the heat dissipation plate 10 can be easier, and the joint part can have improved sealability.

The variation illustrated in FIG. 2B is an example in which a part of the first main surface S1 of the heat dissipation plate 10 includes the joint region R1 to which the housing 20 is joined and the region R2 where the needle-shaped body 12 is located. In this case, another component such as a conductor plate may be located at a remaining region R3 of the first main surface S1.

Fatness of the second main surface S2 and flatness of the joint region R1 of the first main surface S1 may be implemented through abrading or blasting.

As indicated by an imaginary line in FIGs. 1A and 1B, a wick 23 may be located on an inner surface of the housing 20. The wick 23 may not be provided. The wick 23 may be mesh-patterned metallic fiber, a sintered body formed through sintering of metal or ceramic particles, or a communication hole formed by through-holes formed on respective ones of multiple plates communicating with one another when the multiple plates are layered on one another. In a case in which the material of the housing 20 is ceramic, the wick 23 is a ceramic needle-shaped crystal the same as and/or similarly to the plurality of needle-shaped bodies 12 of the heat dissipation plate 10.

<Vapor Chamber Operation>

The vapor chamber 1 with the above configuration may be used while a heat source is in contact with a part of an outer surface of the vapor chamber 1, and a cooling unit such as a heat sink is in contact with another part of the outer surface of the vapor chamber 1. In this configuration, heat of the heat source vaporizes liquid-phase fluid (for example, water) sealed in the space C1 to be gas-phase fluid (for example, vapor), and the cooling unit cools the vaporized gas-phase fluid to be condensed to liquid-phase fluid (for example, water). By circulation of the gas-phase fluid and the liquid-phase fluid described above inside the space C1 while undergoing the above-described phase change, large thermal conduction from the heat source to the cooling unit is implemented.

On an inner surface of the space C1, the needle-shaped body 12 and the wick 23 attract liquid-phase fluid by surface tension. Therefore, liquid-phase fluid is likely to flow near the first main surface S1 where the plurality of needle-shaped bodies 12 is located, and near the inner surface of the housing 20 where the wick 23 is located. On the other hand, gas-phase fluid is likely to flow in open space away from the needle-shaped body 12 and the wick 23. Because of such action, a closed circuit is formed in which gas-phase fluid flows in the space away from the first main surface S1 and the inner surface of the housing 20, and liquid-phase fluid flows near the first main surface S1 and near the inner surface of the space C1. Therefore, gas-phase fluid and liquid-phase fluid achieve smooth circulation.

<Needle-shaped Body>

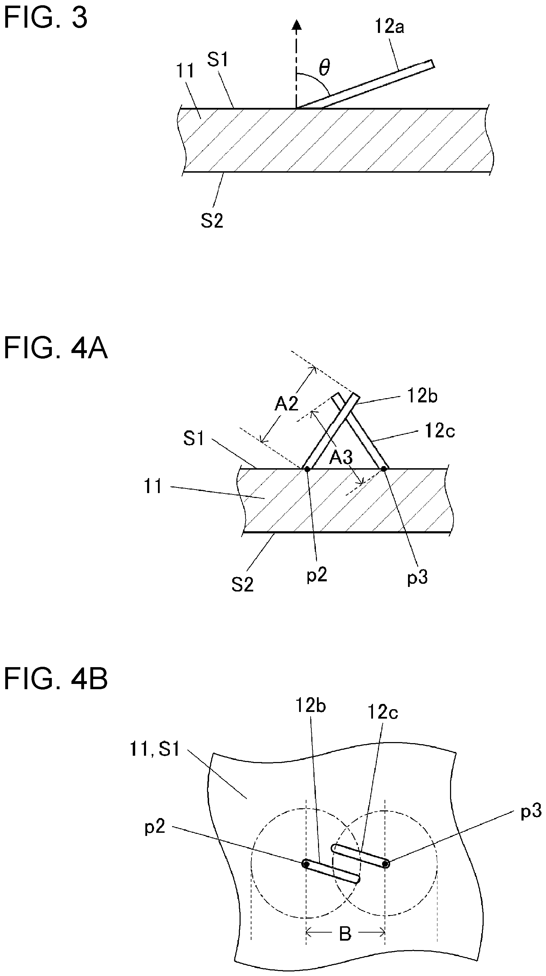

FIG. 3 is a view for explaining a needle-shaped body.

The plurality of needle-shaped bodies 12 may include a first needle-shaped body 12a which inclines at an angle θ of more than 50 degrees with respect to a perpendicular line for the first main surface S1. The plurality of needle-shaped bodies 12 may include a certain number of needle-shaped bodies 12 with such inclination so as to constitute 40% or more. This configuration causes a fine gap between the first needle-shaped body 12a and the first main surface S1 and provides a capacity to attract liquid to the gap based on surface tension. Therefore, the plurality of needle-shaped bodies 12 can demonstrate a function as a wick of the vapor chamber 1.

FIGs. 4A and 4B are views for explaining a pair of needle-shaped bodies intersecting with one another. FIG. 4A is a side view and FIG. 4B is a plan view.

The plurality of needle-shaped bodies 12 includes a second needle-shaped body 12b and a third needle-shaped body 12c which are adjacent to one another. The second needle-shaped body 12b and the third needle-shaped body 12c intersect with one another when seen from a side and may satisfy Formula (1).

$$A2 + A3 > B \ldots (1)$$

Here, A2 is a length of the second needle-shaped body 12b, A3 is a length of the third needle-shaped body 12c, and B is a distance from a base p2 of the second needle-shaped body 12b to a base p3 of the third needle-shaped body 12c. The length means a linear distance from a base to a tip. Seeing from a side means to see in a direction along the first main surface S1, and the side may be a direction orthogonal to a line connecting the base p2 and the base p3. The base of the needle-shaped body means a boundary between the first main surface S1 and the needle-shaped body.

Below, a pair of needle-shaped bodies 12 which satisfies the above condition (that is, intersecting with one another when seen from the side and satisfying Formula (1)) is referred to as an "intersecting pair of needle-shaped bodies 12".

The plurality of needle-shaped bodies 12 may include a certain number of intersecting pairs of needle-shaped bodies 12 so as to constitute 50% or more. The intersecting pair of needle-shaped bodies 12 causes a fine space between the needle-shaped bodies 12 which constitute the pair and provides a high capacity to attract liquid to the space based on surface tension. Therefore, the plurality of needle-shaped bodies 12 can demonstrate a function as a wick of the vapor chamber 1.

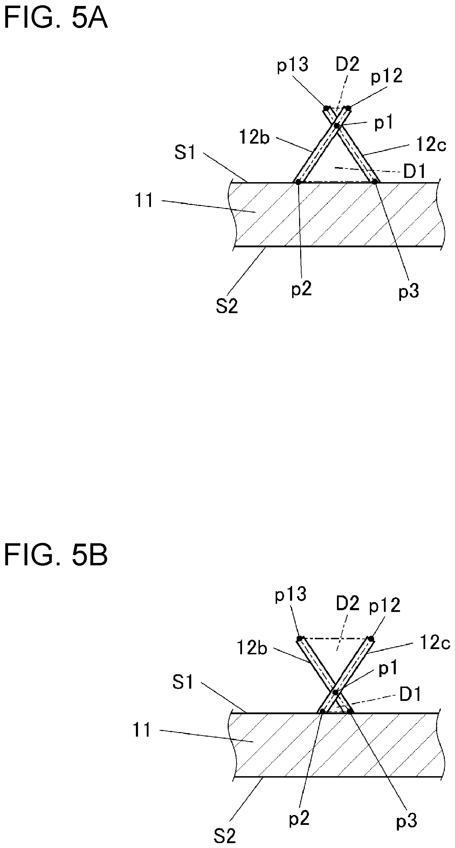

FIG. 5A is a view for explaining a first aspect of intersection of a pair of needle-shaped bodies intersecting with one another. FIG. 5B is a view for explaining a second aspect of intersection of a pair of needle-shaped bodies intersecting with one another.

When seen from the side, a triangular area D2 at a tip side may be smaller than a triangular area D1 at a base side (see FIG. 5A). The triangular area D1 at the base side is formed with three vertices including an intersection point p1 between the second needle-shaped body 12b and the third needle-shaped body 12c, the base p2 of the second needle-shaped body 12b, and the base p3 of the third needle-shaped body 12c. The triangular area D2 at the tip side is formed with three vertices including the intersection point p1, a tip p12 of the second needle-shaped body 12b, and a tip p13 of the third needle-shaped body 12c. This aspect of intersection is referred to as the first aspect.

According to the intersection of the first aspect, a larger amount of liquid is holdable near the surface of the first main surface S1, and thereby the vapor chamber 1 acts to transport a large amount of liquid-phase fluid and can have an increased amount of heat transport.

When seen from the side, the triangular area D2 at the tip side may be larger than the triangular area D1 at the base side (see FIG. 5B). The triangular area D1 at the base side is formed with three vertices including the intersection point p1 between the second needle-shaped body 12b and the third needle-shaped body 12c, the base p2 of the second needle-shaped body 12b, and the base p3 of the third needle-shaped body 12c. The triangular area D2 at the tip side is formed with three vertices including the intersection point p1, the tip p12 of the second needle-shaped body 12b, and the tip p13 of the third needle-shaped body 12c. This aspect of intersection is referred to as the second aspect.

According to the intersection of the second aspect, surface tension causes action to more attract liquid to the surface side of the first main surface S1. Therefore, when the vapor chamber 1 circulates liquid-phase fluid, liquid-phase fluid located on the first main surface S1 can have a reduced thickness. Thereby, liquid-phase fluid in a film shape can have lower thermal resistance.

FIGs. 6A and 6B are views for explaining an arrangement example of a pair of needle-shaped bodies with the intersection of the first aspect and a pair of needle-shaped bodies with the intersection of the second aspect. FIG. 6A is a view for explaining a flow of gas-phase fluid and liquid-phase fluid. FIG. 6B is a view illustrating a placement region on the first main surface. In FIG. 6A, white arrows indicate a flow of gas-phase fluid and hatched arrows indicate a flow of liquid-phase fluid. In FIG. 6B, hatching indicate regions R31 and R32.

In transparent plan view, in a case in which the heat source 41 is located at the center of the vapor chamber 1, the region R31 (see FIG. 6B) at the center of the first main surface S1 may include a larger number of needle-shaped bodies 12 with the intersection of the first aspect than the region R32 (see FIG. 6B) near an edge of the first main surface S1. On the other hand, the region R32 (see FIG. 6B) near the edge of the first main surface S1 may include a larger number of needle-shaped bodies 12 with the intersection of the second aspect than the region R31 (see FIG. 6B) at the center of the first main surface S1.

This distribution of the intersection of the first aspect and the intersection of the second aspect can improve heat exchange efficiency as follows. That is, as illustrated in FIG. 6A, in a case in which the heat source 41 is located at the center of the second main surface S2 or located at the center of the plate-shaped part 21 of the housing 20, vaporization of liquid-phase fluid occurs more in the region R31 of the first main surface S1 closer to the heat source 41. On the other hand, condensation of gas-phase fluid occurs more in the region R32 near the edge of the first main surface S1. When the number of needle-shaped bodies 12 with the intersection of the first aspect (see FIG. 5A) is large, more liquid-phase fluid is holdable near the first main surface S1. Therefore, the number of needle-shaped bodies 12 with the intersection of the first aspect (see FIG. 5A) is desirably large in a region in which condensed liquid-phase fluid circulates toward the heat source 41. On the other hand, when the number of needle-shaped bodies 12 with the intersection of the second aspect (see FIG. 5B) is large, thermal resistance decreases, which facilitates heat exchange for condensation. Therefore, the number of needle-shaped bodies 12 with the intersection of the second aspect (see FIG. 5B) is desirably large in a region in which gas-phase fluid condenses. The fore-mentioned distribution of the intersection of the first aspect and the intersection of the second aspect matches the desirable arrangement described above.

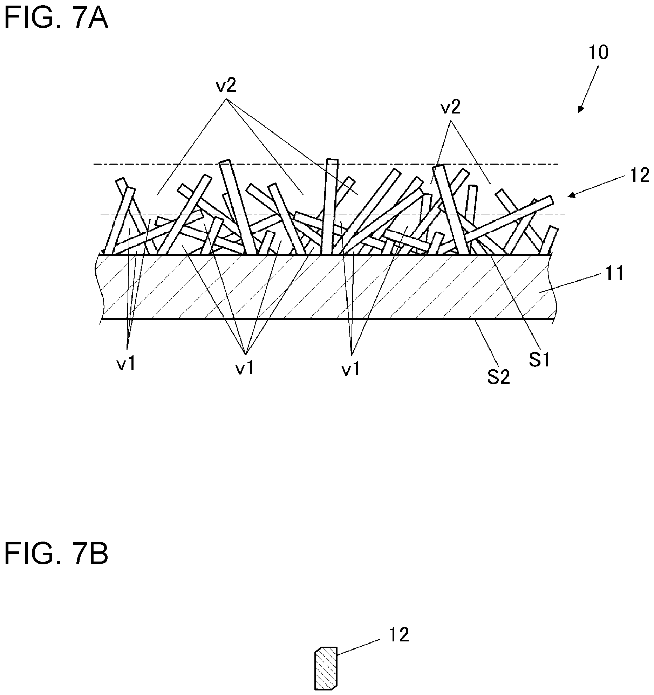

FIG. 7A is a side view illustrating a plurality of needle-shaped bodies. FIG. 7B is a cross-sectional view of a needle-shaped body.

As illustrated in FIG. 7A, the plurality of needle-shaped bodies 12 has an area of a gap v1 smaller than an area of a gap v2 when seen from a side. The gap v1 is included in a region from half the maximum height occupied by the needle-shaped body 12 to the first main surface S1. The gap v2 is included in a region from the half the maximum height on a side opposite to the first main surface S1. The areas of the gaps v1 and v2 can be confirmed through measurement of a range in which, when the heat dissipation plate 10 including the plurality of needle-shaped bodies 12 is sliced in such a manner as to have a given thickness (for example, 5 mm) and have a section perpendicular to the first main surface S1, an opposite side of the plurality of needle-shaped bodies 12 are visible from a position opposed to the sliced surface.

In this configuration, the plurality of needle-shaped bodies 12 acts to attract liquid-phase fluid by surface tension more at the base side closer to the first main surface S1 than at the tip side away from the first main surface S1. Since gas-phase fluid flows in the space away from the first main surface S1, the above-described configuration can reduce turbulence of fluid circulation caused by collision of liquid-phase flow and gas-phase flow at an interface between a flow of gas-phase fluid and a flow of liquid-phase fluid. Therefore, gas-phase fluid and liquid-phase fluid achieve smooth circulation within the space C1 (see FIG. 1B), and heat exchange efficiency can improve.

As illustrated in FIG. 7B, each one of the plurality of needle-shaped bodies 12 may have a polygonal cross section. The needle-shaped body 12 functions to transmit heat applied from outside of the heat dissipation plate 10 to fluid (that is, liquid-phase fluid and gas-phase fluid) or to transmit heat of fluid to outside of the heat dissipation plate 10. The above-described configuration can increase a surface area of the needle-shaped body 12 relative to a volume of the needle-shaped body 12. Therefore, heat exchange efficiency between the needle-shaped body 12 and fluid can improve.

(EMBODIMENT 2)

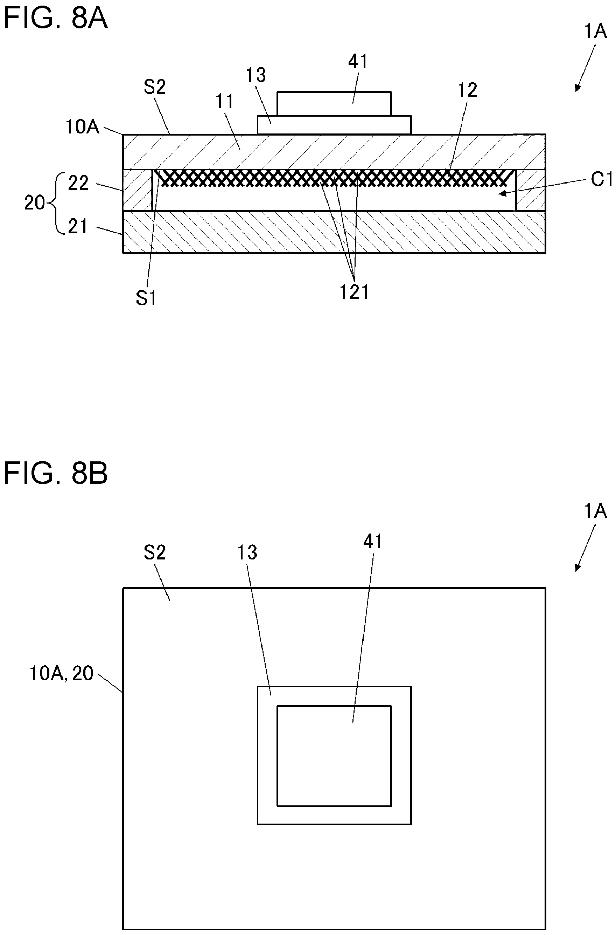

FIG. 8A is a vertical-sectional view illustrating a heat dissipation plate and a vapor chamber according Embodiment 2. FIG. 8B is a plan view illustrating the heat dissipation plate and the vapor chamber according to Embodiment 2.

A heat dissipation plate 10A of Embodiment 2 includes a conductor plate 13 located on the second main surface S2 of the substrate 11. Other configurations of the heat dissipation plate 10A may be the same as and/or similar to those of the heat dissipation plate 10 of Embodiment 1. The conductor plate 13 may be located at the center of the second main surface S2 or located to offset from the center. An upper surface of the conductor plate 13 may be a mounting part on which the heat source 41 (for example, an electronic element) is mounted. The conductor plate 13 is a metalized conductor and may be hardened during and after firing of the heat dissipation plate 10A or formed through vacuum film formation, wet plating, or the like after the firing. A main component of the conductor plate 13 may be copper.

The conductor plate 13 may be a plurality of electrodes. The heat dissipation plate 10A includes a wiring conductor (not illustrated) extending from a plurality of electrodes (for example, the conductor plate 13) along an outer surface of the substrate 11. At least one of an electrical signal or a power-supply voltage may be transmitted to the heat source 41 (for example, an electronic element) via the wiring conductor and the conductor plate 13. The heat dissipation plate 10A including at least one of the electrode or the wiring conductor may be referred to as a circuit board.

A vapor chamber 1A of Embodiment 2 is the same as and/or similar to the vapor chamber 1 of Embodiment 1 except for the conductor plate 13 of the heat dissipation plate 10 A.

According to the heat dissipation plate 10A of Embodiment 2, heat is conducted from the heat source 41 to the heat dissipation plate 10A via the conductor plate 13, and therefore thermal conductivity to the heat dissipation plate 10A can improve. According to the vapor chamber 1A of Embodiment 2, the same as and/or similarly to the vapor chamber 1 of Embodiment 1, the heat source 41 is disposed on the heat dissipation plate 10A side where the plurality of needle-shaped bodies 12 is located and not on the housing side 20. Therefore, the plurality of needle-shaped bodies 12 which acts as a wick can cause liquid-phase fluid to flow toward a heat supply side. Thereby, heat exchange efficiency of the vapor chamber 1A can improve.

(EMBODIMENT 3)

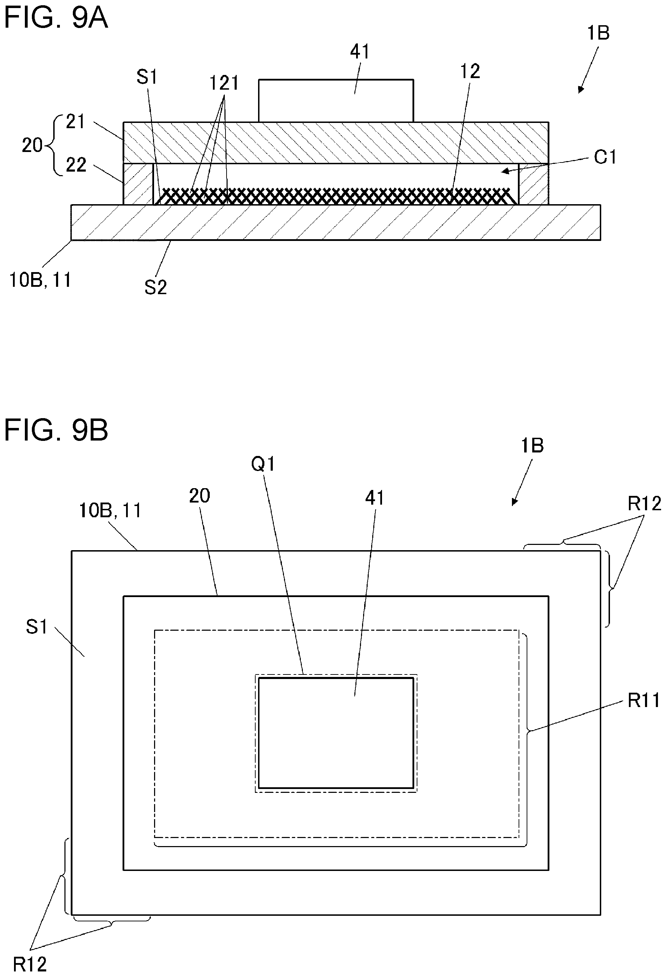

FIG. 9A is a vertical-sectional view illustrating a heat dissipation plate and a vapor chamber according Embodiment 3. FIG. 9B is a plan view illustrating the heat dissipation plate and the vapor chamber according to Embodiment 3.

A heat dissipation plate 10B of Embodiment 3 is the same as and/or similar to the heat dissipation plate 10 of Embodiment 1 except for difference in a configuration of the first main surface S1.

The first main surface S1 of the heat dissipation plate 10B may include a first region R11 where the plurality of needle-shaped bodies 12 is located and a second region R12 which is flatter than the first region R11. The second region R12 may surround the first region R11, and an area of the second region R12 may be larger than an area of the first region R11. Being flat may mean a degree where no needle-shaped crystal or an extremely short needle-shaped crystal exists or mean a planar shape.

In this configuration, the housing 20 with a dimension corresponding to the first region R11 is joined onto the first main surface S1, and thereby a vapor chamber 1B in which the second region R12 of the first main surface S1 is exposed to the outside next to the housing 20 is formed. Since the exposed portion of the first main surface S1 is flat, an effect that another component can be mounted on this portion, or this portion can be pressed for gripping or fixing is obtained.

The exposed portion of the first main surface S1, an internal portion of an insulating portion of the substrate 11, and/or a second main surface S2 may include at least one of an electrode or a wiring conductor which is not illustrated. The heat dissipation plate 10B including at least one of the electrode or the wiring conductor may be referred to as a circuit board.

The housing 20 may be configured as described in Embodiment 1.

In the vapor chamber 1B of Embodiment 2, the heat source 41 may be disposed on the housing 20 side and not on the heat dissipation plate 10B side. That is, a mounting part Q1 (see FIG. 9B) for the heat source 41 may be located on a surface of the plate-shaped part 21 of the housing 20 on a side opposite to the heat dissipation plate 10B.

In this configuration, absorption of heat from a tip side of the plurality of needle-shaped bodies 12 facilitates condensation of gas-phase fluid. Liquid-phase fluid attracted to a vicinity of the first main surface S1 by the plurality of needle-shaped bodies 12 spreads across the region of the first main surface S1 where the needle-shaped body 12 is located, thus being reduced in thickness. Thereby, liquid-phase fluid in a film shape can have lower thermal resistance.

(EMBODIMENTS 4 AND 5)

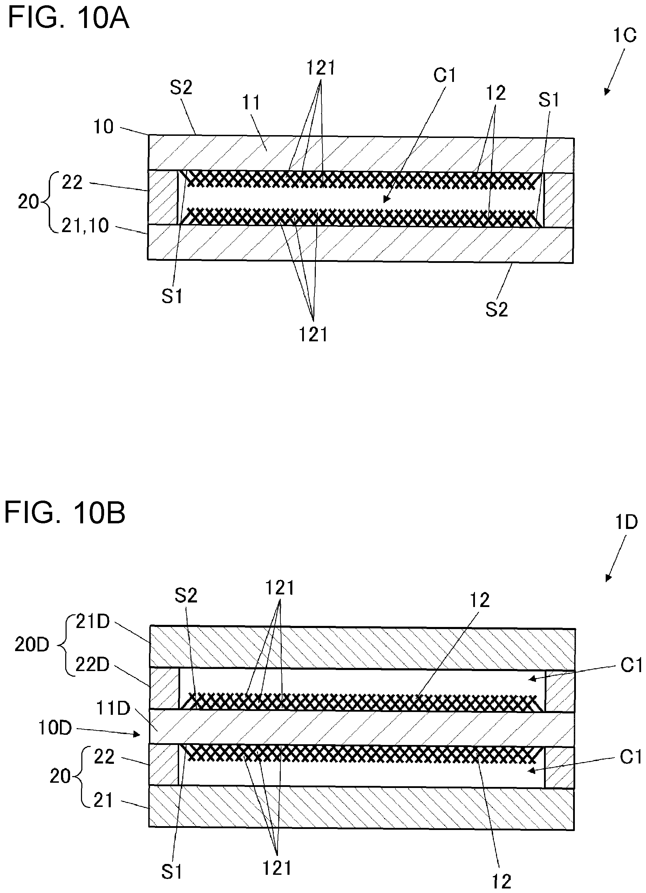

FIG. 10A is a vapor chamber according Embodiment 4. FIG. 10B is a view illustrating a vapor chamber according Embodiment 5.

A vapor chamber 1C (see FIG. 10A) according to Embodiment 4 is an example in which the plate-shaped part 21 of the housing 20 is configured the same as and/or similarly to the heat dissipation plate 10 of Embodiment 1, and other configurations are the same as and/or similar to those of the vapor chamber 1 of Embodiment 1. The first main surface S1 of the heat dissipation plate 10 that is the plate-shaped part 21 is located to face the internal space C1, and the plurality of needle-shaped bodies 12 located on the first main surface S1 of the heat dissipation plate 10 that is the plate-shaped part 21 is located at the internal space C1.

Also in the vapor chamber 1C of this embodiment, the plurality of needle-shaped bodies 12 of the pair of heat dissipation plates 10 opposed to one another acts as a wick, and highly efficient heat exchange is achievable.

In a vapor chamber 1D according to Embodiment 5 (see FIG. 10B), a heat dissipation plate 10D includes a substrate 11D where the plurality of needle-shaped bodies 12 is located on the first main surface S1 and the second main surface S2. The second main surface S2 of the substrate 11D may be configured the same and and/or similarly to the first main surface S1 of the heat dissipation plate 10 of Embodiment 1. A housing 20D is joined also to the second main surface S2 of the substrate 11D. The housing 20D includes a plate-shaped part 21D and a frame part 22D. The housing 20D may be configured the same as and/or similarly to the housing 20 of Embodiment 1. Other configurations are the same as and/or similar to those of the vapor chamber 1 of Embodiment 1.

Also in the vapor chamber 1D of this embodiment, the plurality of needle-shaped bodies 12 of the first main surface S1 and the plurality of needle-shaped bodies 12 of the second main surface S2 act as a wick, and highly efficient heat exchange is achievable.

The embodiments of the present disclosure are described above. However, the heat dissipation plate and the vapor chamber of the present disclosure are not limited to those described in the above embodiments. For example, the internal space of the vapor chamber may be a space expanding to have a plate-like shape or may be a space extending to have a bar-like shape. The heat dissipation plate may surround at least a part of the space. Other than those described above, the details described in the embodiments can appropriately be changed without departing from the spirit of the present invention.

INDUSTRIAL APPLICABILITY

The present disclosure is applicable to a heat dissipation plate and a vapor chamber.

REFERENCE SIGNS

1, 1A-1D vapor chamber
10, 10A, 10B, 10D heat dissipation plate
11, 11D substrate
12 needle-shaped body
121 positioning part (holding part)
12a first needle-shaped body
12b second needle-shaped body
12c third needle-shaped body
13 conductor plate
20, 20D housing
21, 21D plate-shaped part
22, 22D frame part
23 wick
25 pillar-like part
41 heat source
C1 space
D1, D2 area
E1 opening
p1 intersection point
p2, p3 base
p12, p13 tip
Q1 mounting part
R1 joint region
R2 region where plurality of needle-shaped bodies is located
R11 first region
R12 second region
R31 center region
R32 region near edge
S1 first main surface
S2 second main surface
v1, v2 gap

**Claims**

1. A heat dissipation plate comprising:

   a substrate comprising a first main surface and a second main surface located on a side opposite to the first main surface; and
   a plurality of needle-shaped bodies extending outward of the substrate from the first main surface, wherein
   a positioning part where fluid is positioned is provided between respective ones of the plurality of needle-shaped bodies,
   a portion of the substrate is made of ceramic, the portion comprising at least a part of the first main surface, and
   the plurality of needle-shaped bodies is needle-shaped crystals of the ceramic.

2. The heat dissipation plate according to claim 1, wherein the first main surface comprises an annular joint region to which a surface of a housing is joined, the surface being at a periphery of an opening provided to the housing,

   the plurality of needle-shaped bodies is located on an inner side of the joint region, and
   the joint region is flatter than a region where the plurality of needle-shaped bodies is located.

3. The heat dissipation plate according to claim 1 or 2, wherein the second main surface is flatter than a region where the plurality of needle-shaped bodies is located.

4. The heat dissipation plate according to any one of claims 1 to 3, further comprising, between respective ones of the plurality of needle-shaped bodies, a holding part configured to hold liquid-phase fluid.

5. The heat dissipation plate according to any one of claims 1 to 4, wherein the plurality of needle-shaped bodies comprises a first needle-shaped body, and the first needle-shaped body inclines at an angle of more than 50 degrees with respect to a perpendicular line for the first main surface.

6. The heat dissipation plate according to any one of claims 1 to 5, wherein the plurality of needle-shaped bodies comprises a second needle-shaped body and a third needle-shaped body adjacent to one another, and
the second needle-shaped body and the third needle-shaped body intersect with one another when seen from a side, and a length A2 of the second needle-shaped body, a length A3 of the third needle-shaped body, and a distance B from a base of the second needle-shaped body to a base of the third needle-shaped body satisfy a relation of Formula (1):

$$A2 + A3 > B \ldots (1).$$

7. The heat dissipation plate according to claim 6, wherein a triangular area at a tip side is larger than a triangular area at a base side when seen from the side, the triangular area at the base side being formed with three vertices comprising an intersection point between the second needle-shaped body and the third needle-shaped body, the base of the second needle-shaped body, and the base of the third needle-shaped body, and the triangular area at the tip side being formed with three vertices comprising the intersection point, a tip of the second needle-shaped body, and a tip of the third needle-shaped body.

8. The heat dissipation plate according to claim 6, wherein a triangular area at a tip side is smaller than a triangular area at a base side when seen from the side, the triangular area at the base side being formed with three vertices comprising an intersection point between the second needle-shaped body and the third needle-shaped body, the base of the second needle-shaped body, and the base of the third needle-shaped body, and the triangular area at the tip side being formed with three vertices comprising the intersection point, a tip of the second needle-shaped body, and a tip of the third needle-shaped body.

9. The heat dissipation plate according to any one of claims 1 to 8, wherein when the plurality of needle-shaped bodies is seen from a side, an area of a gap in a region from half a maximum height of a range occupied by the plurality of needle-shaped bodies on a side of the first main surface is smaller than an area of a gap in a region from the half the maximum height on a side opposite to the first main surface.

10. The heat dissipation plate according to any one of claims 1 to 9, wherein a respective one of the plurality of needle-shaped bodies has a polygonal cross section.

11. The heat dissipation plate according to any one of claims 1 to 10, further comprising a conductor plate on the second main surface.

12. The heat dissipation plate according to any one of claims 1 to 10, wherein the first main surface comprises a first region where the plurality of needle-shaped bodies is located and a second region flatter than the first region, and
the second region surrounds the first region and has an area larger than an area of the first region.

13. A vapor chamber comprising:

the heat dissipation plate according to any one of claims 1 to 12;
a housing comprising an opening; and
liquid-phase fluid located inside the housing, wherein
the heat dissipation plate covers the opening, and
the plurality of needle-shaped bodies is located inside a space surrounded by the housing and the substrate.

14. The vapor chamber according to claim 13, wherein the housing is made of metal.

15. The vapor chamber according to claim 13 or 14, wherein the housing comprises:

a plate-shaped part opposed to the heat dissipation plate; and
a mounting part for a heat source, and
the mounting part is located on a surface of the plate-shaped part on a side opposite to the heat dissipation plate.

FIG. 1A

10, 11

S2

S1

1

23

25

C1

25

E1

20 { 22
21

25

FIG. 1B

1

S2    11    12   121    E1

10

20 { 22
21

C1

S1    25    23    25

FIG. 2A

FIG. 2B

FIG. 3

FIG. 4A

FIG. 4B

FIG. 5A

FIG. 5B

## FIG. 6A

## FIG. 6B

FIG. 7A

FIG. 7B

FIG. 8A

FIG. 8B

FIG. 9A

FIG. 9B

## FIG. 10A

## FIG. 10B

| INTERNATIONAL SEARCH REPORT | International application No. |
|---|---|
| | **PCT/JP2023/012540** |

**A. CLASSIFICATION OF SUBJECT MATTER**

*F28D 15/02*(2006.01)i; *F28D 15/04*(2006.01)i
FI: F28D15/04 D; F28D15/02 101H; F28D15/02 102A

According to International Patent Classification (IPC) or to both national classification and IPC

**B. FIELDS SEARCHED**

Minimum documentation searched (classification system followed by classification symbols)

F28D15/02; F28D15/04

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2000-150739 A (ELECTROVAC FABRIKATION ELEKTROTECHNISCHER SPEZIALARTIKEL GMBH) 30 May 2000 (2000-05-30) paragraphs [0029]-[0040], fig. 3-4 | 1-10, 12 |
| Y | | 11, 13-15 |
| Y | JP 50-50411 A (HITACHI, LTD.) 06 May 1975 (1975-05-06) p. 2, upper right column, line 1 to lower left column, line 10, fig. 1-2 | 11, 13-15 |
| Y | JP 2010-151354 A (SONY CORP) 08 July 2010 (2010-07-08) paragraph [0079], fig. 29 | 15 |
| A | JP 2009-260168 A (SUMITOMO ELECTRIC IND LTD) 05 November 2009 (2009-11-05) paragraphs [0015]-[0024], fig. 2 | 1-15 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **15 May 2023** | **30 May 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/012540**

| Patent document cited in search report | | | Publication date (day/month/year) | Patent family member(s) | | | Publication date (day/month/year) |
|---|---|---|---|---|---|---|---|
| JP | 2000-150739 | A | 30 May 2000 | US column 4, line 58 to column 6, line 60, fig. 3-4 | 6191944 | B1 | |
| | | | | EP | 999590 | A2 | |
| JP | 50-50411 | A | 06 May 1975 | (Family: none) | | | |
| JP | 2010-151354 | A | 08 July 2010 | US paragraph [0149], fig. 29 | 2010/0157535 | A1 | |
| | | | | CN | 101793472 | A | |
| | | | | KR | 10-2010-0075397 | A | |
| | | | | TW | 201030301 | A | |
| JP | 2009-260168 | A | 05 November 2009 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003254685 A